Europäisches Patentamt

European Patent Office

Office européen des brevets

(19)

(11) Veröffentlichungsnummer: **0 265 373 B1**

(12)
# EUROPÄISCHE PATENTSCHRIFT

(45) Veröffentlichungstag der Patentschrift:
13.03.91 Patentblatt 91/11

(51) Int. Cl.$^5$: **C08G 18/02**, G03F 7/004

(21) Anmeldenummer: 87810525.3

(22) Anmeldetag: 14.09.87

(54) Verfahren zur Härtung von Polyisocyanat-Beschichtungen.

(30) Priorität: 19.09.86 CH 3755/86

(43) Veröffentlichungstag der Anmeldung:
27.04.88 Patentblatt 88/17

(45) Bekanntmachung des Hinweises auf die
Patenterteilung:
13.03.91 Patentblatt 91/11

(84) Benannte Vertragsstaaten:
DE ES FR GB IT

(56) Entgegenhaltungen:
EP-A- 0 094 915
CHEMICAL ABSTRACTS, Band 76, Nr. 24,
12.Juni 1972, Seite 18, Zusammenfassung Nr.
141527h, Columbus, Ohio, US; & SU-A-317 682
(MENDELEEV, D.I., CHEMICAL-TECHNOLOGI-
CAL INSTITUTE, MOSCOW) 19-10-1971

(73) Patentinhaber: CIBA-GEIGY AG
Klybeckstrasse 141
CH-4002 Basel (CH)

(72) Erfinder: Rembold, Manfred, Dr.
Im Aeschfeld 21
CH-4147 Aesch (CH)
Erfinder: Sitek, Franciszek, Dr.
Grossmattweg 11
CH-4106 Therwil (CH)
Erfinder: Rutsch, Werner, Dr.
Avenue Weck-Reynold 1
CH-1700 Fribourg (CH)
Erfinder: Berner, Godwin, Dr.
Sommerhalde 5
CH-4102 Binningen (CH)

## Beschreibung

Die Erfindung betrifft ein Verfahren zur Härtung von Beschichtungen aus Polyisocyanaten in Gegenwart latenter Härtungskatalysatoren aus der Klasse der Ferroceniumsalze sowie die dadurch erhaltenen gehärteten Beschichtungen und die dafür verwendeten Beschichtungsmassen.

Das Verfahren beruht darauf, dass eine Verbindung, die mehr als eine Isocyanatgruppe enthält, polymerisiert wird und dadurch in einen vernetzten, unlöslichen Zustand übergeführt wird. Die Polymerisation geschieht durch Erwärmen in Gegenwart eines Katalysators, der in einer Vorstufe durch Bestrahlung eines latenten Katalysators mit aktinischem Licht gebildet wird. Obwohl die eigentliche Polymerisation ein thermisch-katalytischer Prozess ist, wird das Verfahren durch die Verwendung eines photoaktivierbaren Katalysators ein durch Licht steuerbarer Prozess und lässt sich daher zur Bildaufzeichnung verwenden.

Die Erfindung betrifft ein Verfahren zur Härtung von Polyisocyanat-Beschichtungen, das dadurch gekennzeichnet ist, dass man einem Polyisocyanat eine Ferroceniumverbindung der Formel I,

$$\left[ \, (R^1) \; Fe^{II}(R^2) \, \right]^+_a \quad [X]^{a-} \qquad I$$

worin a 1, 2 oder 3 ist, $R^1$ ein ungeladener carbocyclischer oder heterocyclischer, unsubstituierter oder substituierter aromatischer Ring ist, $R^2$ ein unsubstituiertes oder substituiertes Cyclopentadienyl- oder Indenyl-Anion ist und $[X]^{a-}$ ein Anion aus der Reihe $F^-$, $Cl^-$, $Br^-$, $I^-$, $CN^-$, $NCO^-$, $NCS^-$, $CH_3COO^-$, $CF_3COO^-$, $SO_4^{2-}$, $PO_4^{3-}$, $NO_3^-$, $ClO_4^-$, $[(Phenyl)_4B]^-$, $C_6H_5SO_3^-$, $CH_3C_6H_4SO_3^-$, $CF_3C_6H_4SO_3^-$, $CH_3SO_3^-$, $CF_3SO_3^-$, $C_4F_9SO_3^-$, $C_6F_{13}SO_3^-$, $C_8F_{17}SO_3^-$, $C_6F_5SO_3^-$, $BF_4^-$, $AlF_4^-$, $AlCl_4^-$, $TiF_6^{2-}$, $PF_6^-$, $SbF_6^-$, $SbCl_6^-$, $GeF_6^-$, $ZrF_6^{2-}$, $AsF_6^-$, $FeCl_4^-$, $SnF_6^-$, $SnCl_6^-$ oder $BiCl_6^-$ darstellt, als latenten Härtungskatalysator zugibt, das Gemisch auf das Substrat aufträgt, die Beschichtung mit aktinischem Licht bestrahlt und anschliessend auf 60 bis 200°C erwärmt.

Unter Polyisocyanat versteht man eine organische Verbindung, die mehr als eine Isocyanatgruppe in ihrem Molekül enthält. Bevorzugt verwendet man ein aliphatisches Di- oder Triisocyanat, bzw. Gemische solcher Verbindungen. Bevorzugt verwendet man Polyisocyanate, die einen niedrigen Dampfdruck haben, damit sie sich beim Erwärmen der Beschichtung nicht verflüchtigen und damit keine gewerbehygienischen Probleme auftreten. Solche Polyisocyanate mit niedrigem Dampfdruck haben meist ein höheres Molekulargewicht und lassen sich z.B. durch Umsetzung niedermolekularer Diisocyanate mit unterschüssigen Mengen eines Polyols herstellen. Andere Beispiele für Polyisocyanate mit niedrigem Dampfdruck sind Dimere oder Trimere von Diisocyanaten. Man bezeichnet solche Polyisocyanate von höherem Molekulargewicht auch als präpolymere Polyisocyanate. Verschiedene solcher Produkte sind im Handel erhältlich und werden vor allem zur Herstellung von Polyurethanlacken gebraucht. Eine Uebersicht über solche Produkte findet sich z.B. in Wagner-Sarx, Lackkunstharze, Verlag C. Hanser, München 1971, Seite 157-164.

Dem Polyisocyanat bzw. Polyisocyanat-Gemisch können auch kleinere Mengen eines Monoisocyanates zugemischt werden. Diese Monoisocyanate werden in das vernetzte Produkt chemisch eingebaut (copolymerisiert) und können daher z.B. als Reaktiv-Verdünner oder zur Modifizierung der physikalischen Eigenschaften des Harzes dienen. Man verwendet voruzgsweise nicht mehr als 30 Gew.-% Monoisocyanat, bezogen auf das Polyisocyanat.

Die als latente Härtungskatalysatoren verwendeten Verbindungen der Formel I sind salzartige Derivate des Ferrocen. In Formel I ist $R^1$ ein ungeladenes π-Aren und kann ein heterocyclisches oder carbocyclisches Aren sein. Vorzugsweise ist $R^1$ ein carbocyclisches Aren. Beispiele für heterocyclische Arene und deren Substitutionsprodukte sind 5- oder 6-gliedrige O-, N- und/oder S-Atome enthaltende Heteroaromaten und deren Anellierungsderivate und Alkylderivate, wie z.B. Thiophen, Chromen, Xanthen, Thioxanthen, Benzothiophen, Naphthothiophen, Thiantren, Diphenylenoxid, Diphenylensulfid, Methylxanthen, Isopropylthioxanthen, 3-Methylbenzothiophen, Pyridin, Chinolin, Chinaldin, Isochinolin, Carbazol, N-Methylcarbazol, Acridin, Phenazin oder N-Ethylphenthiazin. Beispiele für unsubstituierte carbocyclische Arene sind vor allem Benzol, Naphthalin, Inden, Fluoren, Pyren, Phenanthren, Anthracen, 9,10-Dihydroanthracen, Tetrahydronaphthalin, Naphthacen, Coronen, Biphenylen oder Triphenylen. Beispiele für substituierte carbocyclische Arene sind vor allem durch $C_1$-$C_{14}$-Alkyl, Halogen, Phenyl, $C_1$-$C_{10}$-Alkoxy, Cyan, $C_7$-$C_{12}$-Alkylphenyl, $C_7$-$C_{11}$-Phenylalkyl, $C_8$-$C_{18}$-Alkylphenylalkyl, $C_2$-$C_{13}$-Alkoxycarbonyl, Phenoxy, Phenylthio, Phenoxycarbonyl, Styryl, $C_1$-$C_4$-Alkyl-styryl oder $C_1$-$C_4$-Alkoxy-styryl substituiertes Benzol, Naphthalin oder Anthracen. Beispiele hierfür sind Toluol, Xylol, Ethylbenzol, Cumol, tert.Butylbenzol, Methylnaphthalin, Methoxybenzol, Ethoxybenzol, Dimethoxybenzol, Chlorbenzol, Brombenzol, Dichlorbenzol, Chlornaphthalin, Bromnaphthalin, Benzonitril, Benzoesäure-methyl- oder -dodecylester, Diphenylether, Diphenylsulfid, Stilben, 4,4'-Dimethylstilben, 4,4'-Dimethoxystilben, 9-Benzylanthracen oder 9-(4-Butylbenzyl) anthracen.

2

Bevorzugt ist R¹ Benzol, Toluol, Xylol, Cumol, Methoxybenzol, Chlorbenzol, 4-Chlortoluol, Naphthalin, Methylnaphthalin, Chlornaphthalin, Methoxynaphthalin, Diphenyl, Inden, Pyren, Diphenylensulfid, Diphenylether, Stilben oder 9-(4-Butylbenzyl) anthracen, und besonders bevorzugt Toluol, Xylol, Cumol oder 4-Chlortoluol.

$R^2$ in der Bedeutung eines substituierten Cyclopentadienyl- oder Indenyl-Anions kann insbesondere ein durch $C_1$-$C_8$-Alkyl, $C_2$-$C_5$-Alkanoyl, $C_2$-$C_6$-Alkoxycarbonyl, Cyan oder Phenyl substituiertes Cyclopentadienyl- oder Indenyl-Anion sein. Beispiele hierfür sind die Anionen von Methyl-, Ethyl-, n-Propyl-, Isopropyl-, n-Butyl-, tert.Butyl-, n-Hexyl- oder n-Octylcyclopentadien, Methyl-, Ethyl-oder Isopropylinden, Dimethylcyclopentadien, Acetyl-, Propionyl-oder Butyrylcyclopentadien, Cyclopentadiencarbonsäure-methyl- oder -ethylester oder Cyaninden. Bevorzugt ist $R^2$ ein Cyclopentadienyl-oder ($C_1$-$C_4$-Alkyl)-cyclopentadienyl-Anion.

Das Anion $[X]^{a-}$ ist bevorzugt ein einwertiges Anion, insbesondere eines aus der Reihe $BF_4^-$, $PF_6^-$, $SbF_6^-$, $AsF_6^-$, $CF_3SO_3^-$, $C_4F_9SO_3^-$, $C_8F_{17}SO_3^-$ oder $CF_3COO^-$.

Beispiele für Verbindungen, die erfindungsgemäss als latente Härtungskatalysatoren verwendet werden können, sind die folgenden:

($\eta^6$-Benzol) ($\eta^5$-cyclopentadienyl)-eisen (II)-hexafluorphosphat

($\eta^6$-Toluol) ($\eta^5$-indenyl)-eisen (II)-hexafluorphosphat

($\eta^6$-Toluol) ($\eta^5$-cyclopentadienyl)-eisen (II)-tetrafluorborat

($\eta^6$-Toluol) ($\eta^5$-cyclopentadienyl)-eisen (II)-hexafluorantimonat

($\eta^6$-Ethylbenzol) ($\eta^5$-cyclopentadienyl)-eisen (II)-hexafluorantimonat

($\eta^6$-Cumol) ($\eta^5$-cyclopentadienyl)-eisen (II)-hexafluorphosphat

($\eta^6$-Cumol) ($\eta^5$-cyclopentadienyl)-eisen (II)-hexafluorantimonat

($\eta^6$-Cumol) ($\eta^5$-methylcyclopentadienyl)-eisen (II)-hexafluorarsenat

($\eta^6$-Cumol) ($\eta^5$-methylcyclopentadienyl)-eisen (II)-tetrafluorborat

($\eta^6$-Cumol)($\eta^5$-indenyl)-eisen (II)-tetrafluorborat

($\eta^6$-Xylol) ($\eta^5$-cyclopentadienyl)-eisen (II)-perchlorat

($\eta^6$-Mesitylen) ($\eta^5$-cyclopentadienyl)-eisen (II)-hexafluorphosphat

($\eta^6$-Methoxybenzol) ($\eta^5$-cyclopentadienyl)-eisen (II)-hexfluorantimonat

($\eta^6$-Chlortoluol) ($\eta^5$-cyclopentadienyl)-eisen (II)-hexafluorphosphat

($\eta^6$-Naphthalin) ($\eta^5$-cyclopentadienyl)-eisen (II)-hexafluorphosphat

($\eta^6$-Naphthalin) ($\eta^5$-cyclopentadienyl)-eisen (II)-hexafluorantimonat

($\eta^6$-1-Methylnaphthalin) ($\eta^5$-cyclopentadienyl)-eisen (II)-hexafluorphosphat

($\eta^6$-2-Methylnaphthalin) ($\eta^5$-cyclopentadienyl)-eisen (II)-hexafluorantimonat

($\eta^6$-1-Chlornaphthalin) ($\eta^5$-cyclopentadienyl)-eisen (II)-hexafluorphosphat

($\eta^6$-2-Methoxynaphthalin) ($\eta^5$-cyclopentaddienyl)-eisen (II)-hexafluorantimonat

($\eta^6$-Diphenyl) ($\eta^5$-cyclopentadienyl)-eisen (II)-hexafluorarsenat

($\eta^6$-Diphenylensulfid) ($\eta^5$-cyclopentadienyl)-eisen (II)-hexafluorphosphat

($\eta^6$-Pyren) ($\eta^5$-cyclopentadienyl)-eisen (II)-hexafluorphosphat

($\eta^6$-Anthracen) ($\eta^5$-cyclopentadienyl)-eisen (II)-hexafluorphosphat

($\eta^6$-Perylen) ($\eta^5$-methylcyclopentadien)-eisen (II)-hexafluorphosphat

($\eta^6$-Inden) ($\eta^5$-indenyl)-eisen (II)-hexafluorphosphat

($\eta^6$-9, 10-Dihydroanthracen) ($\eta^5$-cyclopentadienyl)-eisen (II)-hexafluorantimonat

($\eta^6$-Stilben) ($\eta^5$-cyclopentadienyl)-eisen (II)-hexafluorphosphat

($\eta^6$-9-[4-Butylbenzyl] anthracen) ($\eta^5$-cyclopentadienyl)-eisen (II)-hexafluorphosphat

($\eta^6$-Cumol) ($\eta^5$-cyclopentadienyl)-eisen (II)-acetat

($\eta^6$-Cumol) ($\eta^5$-cyclopentadienyl)-eisen (II)-trifluoracetat

($\eta^6$-Cumol) ($\eta^5$-cyclopentadienyl)-eisen (II)-toluolsulfonat

($\eta^6$-Cumol) ($\eta^5$-cyclopentadienyl)-eisen (II)-trifluormethansulfonat

($\eta^6$-Cumol) ($\eta^5$-cyclopentadienyl)-eisen (II)-perfluoroctansulfonat

($\eta^6$-2-Methylnaphthalin) ($\eta^5$-cyclopentadienyl)-eisen (II)-hexafluorphosphat

($\eta^6$-2-Methylnaphthalin) ($\eta^5$-cyclopentadienyl)-eisen (II)-trifluormethansulfonat

($\eta^6$-2-Methylnaphthalin) ($\eta^5$-cyclopentadienyl)-eisen (II)-perfluoroctansulfonat.

Die Verbindungen der Formel I sind bekannte Verbindungen oder können in Analogie zu bekannten Verbindungen hergestellt werden. So werden z.B. in der EP-A-94915 und EP-A-109851 eine Reihe solcher Verbindungen und ihre Herstellung beschrieben. Dort ist auch die Verwendung dieser Verbindungen als latente Härtungskatalysatoren für kationisch polymerisierbare Materialien, insbesondere für Epoxidharze beschrieben.

Es war jedoch nicht zu erwarten, dass diese Verbindungen auch latente Härtungskatalysatoren für Isocyanatverbindungen sind. Polyisocyanate werden üblicherweise durch Reaktion mit einem Polyol oder Polyamin gehärtet, also durch eine Zweikomponenten-Polyaddition und nicht durch eine Polymerisation des Isocyanates. Bekannt sind Verfahren zur cyclisierenden Di- und Trimerisation von Isocyanaten, wofür vor allem tertiäre Phosphine, tertiäre Amine oder Alkalimetallhydroxide oder -alkoholate als Katalysatoren verwendet werden.

Die Wirksamkeit der beschriebenen Katalystoren kann durch Zusatz bestimmter Sensibilisatoren gesteigert werden, wie das in der EP-A-152 377 beschrieben ist. Es handelt sich dabei um Verbindungen mit einer Triplett-Energie von mindestens 30 kcal/Mol. Beispiele hierfür sind Verbindungen aus der Klasse der Thioxanthone, Phthalimide, Cumarine und der polycyclischen aromatischen Verbindungen. Bevorzugt eignen sich Thioxanthon, Anthracen und deren Derivate.

Man verwendet den latenten Härtungskatalysator im allgemeinen in einer Menge von 0,05 bis 10 Gew.-%, vorzugsweise 0,6 bis 6 Gew.-%, bezogen auf das Polyisocyanat bzw. Polyisocyanatgemisch. Wenn ausserdem ein Sensibilisator zugesetzt wird, so verwendet man diesen zweckmässig in einer Menge von 0,05 bis 5 Gew.-%, vorzugsweise 0,1 bis 1,5 Gew.-%, bezogen auf das Polyisocyanat.

Der Katalysator und gegebenenfalls der Sensibilisator kann dem Polyisocyanat als solcher zugemischt werden. Bevorzugt löst man den Katalysator in einer kleinen Menge eines gegen Isocyanate inerten Lösungsmittels vor, um den Mischvorgang zu beschleunigen.

Gleichzeitig können dem Polyisocyanat auch noch andere Zusätze zugesetzt werden, wie sie für Beschichtungen üblich sind. Dies sind vor allem Lösungsmittel, Pigmente, Farbstoffe, Verlaufshilfsmittel, Thixotropiemittel, Haftungsvermittler, Antistatika, Lichtschutzmittel oder Antioxidantien.

Die mit dem latenten Katalysator vermischten Polyisocyanat-Beschichtungsmassen, die auch noch andere Zusätze enthalten können, sind unter Ausschluss von Licht und Wärme lagerfähig. Die Erfindung betrifft daher auch Beschichtungsmassen aus einem oder mehreren Polyisocyanaten, enthaltend als latenten Härtungskatalysator 0,05 bis 10. Gew.-%, bezogen auf das Polyisocyanat, einer Verbindung der Formel I.

Als Substrat, das erfindungsgemäss beschichtet werden kann, eignen sich alle festen Materialien, wie z.B. Metalle, keramische Materialien, Glas, Kunststoffe, Kautschuke, Textilien, Holz oder Papier. Die Beschichtungsmassen werden – gegebenenfalls nach Verdünnung mit einem Lösungsmittel – nach den in der Technik üblichen Beschichtungsmethoden auf das Substrat aufgebracht, beispielsweise durch Streichen, Rollen, Spritzen oder Tauchen. Die so aufgebrachte Beschichtung wird nun einer Bestrahlung mit aktinischem Licht unterworfen.

Zur Bestrahlung werden vor allem die in der UV-Technologie üblichen Bestrahlungsapparaturen verwendet. Meist wird darin das Werkstück unter einer oder mehreren Lichtquellen vorbeitransportiert. Als Lichtquellen eignen sich beispielsweise Xenonlampen, Argonlampen, Wolframlampen, Kohlelichtbogenlampen, Metallhalogenidlampen oder Metall-Lichtbogenlampen, wie z.B. Quecksilberniederdruck-, -mitteldruck- oder -hochdrucklampen. Das Licht dieser Lampen ist reich an aktinischem Licht mit Wellenlängen im Bereich von 200-600 nm. Die Bestrahlungszeiten liegen im allgemeinen zwischen einer Sekunde und einer Minute, vorzugsweise bei 5-20 Sekunden. Auch Laserstrahlung, wie z.B. Argonionenlaserstrahlung, eignet sich zur Härtung der Beschichtungen.

Im Anschluss an die Bestrahlung wird die Beschichtung durch Erwärmen auf 60 bis 200°C gehärtet. Die Temperatur richtet sich nach dem Material des Substrates sowie der gewünschten Härtungszeit. Bevorzugt härtet man bei 100 bis 140°C. Hierzu können die in der Lacktechnologie gebräuchlichen Verfahren und Geräte verwendet werden, wie Infrarot-Bestrahlung, induktive Heizung, insbesondere aber die Heissluft- und Ofenerwärmung.

Die so erhaltenen gehärteten Beschichtungen sind klare harte Filme, die in Wasser oder organischen Lösungsmitteln unlöslich sind. Sie eignen sich daher als Schutzüberzüge für die jeweiligen Substrate. Besonders geeignet sind die erfindungsgemässen Beschichtungsmassen für Bildaufzeichnungsverfahren. Hierbei wird die Beschichtung bildmässig belichtet, anschliessend erwärmt und dann mit einem Lösungsmittel entwickelt. Es entsteht dabei ein Negativbild in derjenigen Farbe, mit der die Beschichtungsmasse angefärbt ist. Eine weitere wichtige Anwendung des Verfahrens ist die Herstellung von gedruckten Schaltungen. Hierbei wird die erfindungsgemässe Beschichtungsmasse auf eine Metallschicht aufgebracht. Nach Belichtung, Härtung und Entwicklung kann das Metall an den unbelichteten Stellen weggeätzt werden.

Die folgenden Beispiele erläutern das Verfahren näher, ohne es darauf zu beschränken. Teile bedeuten darin Gewichtsteile und Prozente bedeuten Gewichtsprozente, soweit nicht anders angegeben.

Beispiel 1

100 Teile einer 90%igen Lösung eines aliphatischen Polyisocyanates in Butylacetat/Solventnaphtha 1 :1 (Desmodur® N 3390) werden mit einer 50%igen Lösung von 3,6 Teilen des latenten Härtungskatalysators K-1 = ($\eta^6$-Cumol) ($\eta^5$-cyclopentadienyl)-eisen (II)-hexafluorphosphat in Propylencarbonat vermischt.

Das Gemisch wird in einer Schichtdicke von 100 μm auf eine 200 μm starke Aluminiumfolie aufgetragen

4

und in einem RPC-Belichtungsapparat mit 2 Hg-Mitteldrucklampen von 80 W/cm verschieden lange bestrahlt (4,2 s, 8,4 s, 12,6 s). Anschliessend werden die Proben 30 Min in einem Umluftofen bei 120°C gehärtet. Nach 30 Min. wird die Pendelhärte der Beschichtungen nach der Methode von Koenig (DIN 53 157) gemessen. Als Vergleich wird eine katalysatorfreie Beschichtungsmasse verwendet.

| Katalysator | Bestrahlungszeit | Pendelhärte (s) nach 30 Min. bei 120°C |
|---|---|---|
| keiner | 0 | 0 |
| 4 % K-1 | 0 | 0 |
| 4 % K-1 | 4,2 s | 140 |
| 4 % K-1 | 8,2 s | 170 |
| 4 % K-1 | 12,6 s | 190 |

Beispiel 2

Die in Beispiel 1 beschriebene Beschichtungsmasse (Desmodur® N 3390 mit 4% K-1) wird in einer Schicht von 100 μm auf eine 200 μm starke Aluminiumfolie aufgetragen und mit einer 76 μm starken Polyesterfolie abgedeckt. Ueber die Folie wird ein optischer Keil mit 21 Stufen der Durchlässigkeit (Stouffer-Keil) gelegt und die Proben mit einer 5 kW-Metallhalogenid-Lampe im Abstand von 30 cm verschieden lang bestrahlt (20, 40 und 60 s).

Nach Entfernung der Abdeckfolien werden die Proben 20 und 30 Minuten in einem Umluftofen auf 120°C erhitzt. Die so gehärteten Proben werden 30 s in einem Ultraschall-Entwicklungsbad mit Trichlorethylen ausgewaschen. Nach dem Trocknen wird die letzte noch ausgebildete Stufe bestimmt. Die Ergebnisse sind in der folgenden Tabelle aufgeführt.

| Belichtungszeit | Abbildungsstufe nach thermischer Härtungszeit von | |
|---|---|---|
| | 20 min | 30 min |
| 20 s | 3 | 4 |
| 40 s | 5 | 7 |
| 60 s | 6 | 8 |

Derselbe Versuch wird unter Verwendung von 4% K-2 = ($\eta^6$-Cumol) ($\eta^5$-cyclopentadienyl)-eisen (II)-trifluormethansulfonat durchgeführt und erbringt die folgenden Resultate :

| Belichtungszeit | Abbildungsstufe nach thermischer Härtungszeit von | |
|---|---|---|
| | 15 min | 30 min |
| 20 s | 10 | 21 |
| 40 s | 11 | 21 |
| 60 s | 12 | 21 |

## Ansprüche

1. Verfahren zur Härtung von Beschichtungen auf Basis von Polyisocyanat, dadurch gekennzeichnet, dass man einem Polyisocyanat, gegebenenfalls neben üblichen Zusatzmitteln, eine Ferroceniumverbindung der Formel I,

$$[ (R^1) Fe^{II}(R^2) ]_a^+ \quad [X]^{a-} \qquad I$$

worin a 1, 2 oder 3 ist, $R^1$ ein ungeladener carbocyclischer oder heterocyclischer, unsubstituierter oder substituierter aromatischer Ring ist, $R^2$ ein unsubstituiertes oder substituiertes Cyclopentadienyl- oder Indenyl-Anion ist und $[X]^{a-}$ ein Anion aus der Reihe $F^-$, $Cl^-$, $Br^-$, $I^-$, $CN^-$, $NCO^-$, $NCS^-$, $CH_3COO^-$, $CF_3COO^-$, $SO_4^{2-}$, $PO_4^{3-}$, $NO_3^-$, $ClO_4^-$, $[(Phenyl)_4B]^-$, $C_6H_5SO_3^-$, $CH_3C_6H_4SO_3^-$, $CF_3C_6H_4SO_3^-$, $CH_3SO_3^-$, $CF_3SO_3^-$, $C_4F_9SO_3^-$, $C_6F_{13}SO_3^-$, $C_8F_{17}SO_3^-$, $C_6F_5SO_3^-$, $BF_4^-$, $AlF_4^-$, $AlCl_4^-$, $TiF_6^{2-}$, $PF_6^-$, $SbF_6^-$, $SbCl_6^-$, $GeF_6^-$, $ZrF_6^{2-}$, $AsF_6^-$, $FeCl_4^-$, $SnF_6^-$, $SnCl_6^-$ oder $BiCl_6^-$ darstellt, als latenten Härtungskatalysator zugibt, das Gemisch auf ein Substrat aufträgt, die Beschichtung mit aktinischem Licht bestrahlt und anschliessend auf 60 bis 200°C erwärmt.

2. Verfahren gemäss Anspruch 1, dadurch gekennzeichnet, dass man als Polyisocyanat ein Gemisch von Polyisocyanaten verwendet.

3. Verfahren gemäss Anspruch 1, dadurch gekennzeichnet, dass man als Polyisocyanat ein aliphatisches Di- oder Triisocyanat verwendet.

4. Verfahren gemäss Anspruch 1, dadurch gekennzeichnet, dass man dem Polyisocyanat eine kleinere Menge eines Monoisocyanates zusetzt.

5. Verfahren gemäss Anspruch 1, dadurch gekennzeichnet, dass man 0,05 bis 10 Gew.-%, bezogen auf das Polyisocyanat, an Härtungskatalysator der Formel I verwendet.

6. Verfahren gemäss Anspruch 1, dadurch gekennzeichnet, dass man als Katalysator eine Verbindung der Formel I verwendet, worin $R^1$ Benzol, Toluol, Xylol, Cumol, Methoxybenzol, Chlorbenzol, 4-Chlortoluol, Naphthalin, Methylnaphthalin, Chlornaphthalin, Methoxynaphthalin, Diphenyl, Inden, Pyren, Diphenylensulfid, Diphenylether, Stilben oder 9-(4-Butylbenzyl)anthracen ist.

7. Verfahren gemäss Anspruch 1, dadurch gekennzeichnet, dass man als Katalysator eine Verbindung der Formel I verwendet, worin $R^1$ Toluol, Xylol, Cumol oder 4-Chlortoluol ist.

8. Verfahren gemäss Anspruch 1, dadurch gekennzeichnet, dass man als Katalysator eine Verbindung der Formel I verwendet, worin $R^2$ ein Cyclopentadienyl- oder ($C_1$-$C_4$-Alkyl)-cyclopentadienyl-Anion ist.

9. Verfahren gemäss Anspruch 1, dadurch gekennzeichnet, dass man als Katalysator eine Verbindung der Formel I verwendet, worin a = 1 und $X^-$ ein Anion aus der Reihe $BF_4^-$, $PF_6^-$, $SbF_6^-$, $AsF_6^-$, $CF_3SO_3^-$, $C_4F_9SO_3^-$, $C_8F_{17}SO_3^-$ oder $CF_3COO^-$ ist.

10. Verfahren gemäss Anspruch 1, dadurch gekennzeichnet, dass man zur Bestrahlung Licht von der Wellenlänge 200-600 nm verwendet.

11. Gehärtete Beschichtung, erhältlich gemäss dem Verfahren des Anspruches 1.

12. Beschichtungsmasse aus einem Polyisocyanat oder Polyisocyanatgemisch, enthaltend als latenten Härtungskatalysator 0,05 bis 10 Gew.-%, bezogen auf das Isocyanat(gemisch), einer Verbindung der Formel I gemäss Anspruch 1.

13. Verwendung von Beschichtungsmassen gemäss Anspruch 12 in Bildaufzeichnungsverfahren.

14. Verwendung nach Anspruch 13 zur Herstellung von Reliefabbildungen.

15. Verfahren zur photographischen Herstellung von Abbildungen, dadurch gekennzeichnet, dass man ein mit einer Beschichtung gemäss Anspruch 11 beschichtetes Substrat bildmässig belichtet, anschliessend erwärmt und dann die unbelichteten Anteile mit einem Lösungsmittel entfernt.

## Claims

1. A process for curing polyisocyanate-based coatings, which comprises adding a ferrocenium compound of the formula I

$$[ (R^1) Fe^{II}(R^2) ]_a^+ \quad [X]^{a-} \qquad I$$

in which a is 1, 2 or 3, $R^1$ is an uncharged carbocyclic or heterocyclic, unsubstituted or substituted aromatic ring, $R^2$ is an unsubstituted or substituted cyclopentadienyl or indenyl anion and $[X]^{a-}$ is an anion from the series comprising $F^-$, $Cl^-$, $Br^-$, $I^-$, $CN^-$, $NCO^-$, $NCS^-$, $CH_3COO^-$, $CF_3COO^-$, $SO_4^{2-}$, $PO_4^{3-}$, $NO_3^-$, $ClO_4^-$, $[(phenyl)_4B]^-$, $C_6H_5SO_3^-$, $CH_3C_6H_4SO_3^-$, $CF_3C_6H_4SO_3^-$, $CH_3SO_3^-$, $CF_3SO_3^-$, $C_4F_9SO_3^-$, $C_6F_{13}SO_3^-$, $C_8F_{17}SO_3^-$, $C_6F_5SO_3^-$, $BF_4^-$, $AlF_4^-$, $AlCl_4^-$, $TiF_6^{2-}$, $PF_6^-$, $SbF_6^-$, $SbCl_6^-$, $GeF_6^-$, $ZrF_6^{2-}$, $AsF_6^-$, $FeCl_4^-$, $SnF_6^-$, $SnCl_6^-$ or $BiCl_6^-$, as a latent curing catalyst to a polyisocyanate, optionally together with customary additives, applying a mixture to a substrate, irradiating the coating with actinic light and then heating it to 60-200°C.

2. A process according to claim 1, wherein a mixture of polyisocyanates is used as the polyisocyanate.

3. A process according to claim 1, wherein an aliphatic diisocyanate or triisocyanate is used as the polyisocyanate.

4. A process according to claim 1, wherein a minor quantity of a monoisocyanate is added to the polyisocyanate.

5. A process according to claim 1, wherein 0.05 to 10% by weight, relative to the polyisocyanate, of the curing catalyst of the formula I is used

6. A process according to claim 1, wherein the catalyst used is a compound of the formula I, in which $R^1$ is benzene, toluene, xylene, cumene, methoxybenzene, chlorobenzene, 4-chlorotoluene, naphthalene, methylnaphthalene, chloronaphthalene, methoxynaphthalene, diphenyl, indene, pyrene, diphenylene sulfide, diphenyl ether, stilbene or 9-(4-butylbenzyl)-anthracene.

7. A process according to claim 1, wherein the catalyst used is a compound of the formula I, in which $R^1$ is toluene, xylene, cumene or 4-chlorotoluene

8. A process according to claim 1, wherein the catalyst used is a compound of the formula I, in which $R^2$ is a cyclopentadienyl or $(C_1-C_4-alkyl)$-cyclopentadienyl anion.

9. A process according to claim 1, wherein the catalyst used is a compound of the formula I, in which a is 1 and $X^-$ is an anion from the series $BF_4^-$, $PF_6^-$, $SbF_6^-$, $AsF_6^-$, $CF_3SO_3^-$, $C_4F_9SO_3^-$, $C_8F_{17}SO_3^-$ or $CF_3COO^-$.

10. A process according to claim 1, wherein light of 200-600 nm wavelength is used for irradiation.

11. A cured coating, obtainable according to the process of claim 1

12. A coating composition of a polyisocyanate or polyisocyanate mixture, containing 0.05 to 10% by weight, relative to the isocyanate (mixture), of a compound of the formula I according to claim 1 as a latent curing catalyst.

13. The use of a coating composition according to claim 12 in image recording processes.

14. The use according to claim 13 for the production of relief images

15. A process for the photographic production of images, which comprises imagewise exposing a substrate coated with a coating according to claim 11, then heating and subsequently removing the unexposed areas by means of a solvent

## Revendications

1. Procédé pour durcir des revêtements à base de poly-isocyanates, procédé caractérisé en ce qu'on ajoute à un poly-isocyanate, éventuellement en plus d'additifs usuels, un composé de ferrocénium répondant à la formule I :

$$[ (R^1)\ Fe^{II}(R^2) ]_a^+\quad [X]^{a-}\qquad\qquad I$$

dans laquelle : a est égal à 1, à 2 ou à 3, $R^1$ représente un cycle aromatique carbocyclique ou un hétérocyclique, non chargé, substitué ou non, $R^2$ représente un anion cyclopentadiényle ou indényle substitué ou non et $X^{a-}$ représente un anion pris dans l'ensemble constitué par $F^-$, $Cl^-$, $Br^-$, $I^-$, $CN^-$, $NCO^-$, $NCS^-$, $CH_3COO^-$, $CF_3COO^-$, $SO_4^{2-}$, $PO_4^{3-}$, $NO_3^-$, $ClO_4^-$, $[(phényl)_4B]^-$, $C_6H_5SO_3^-$, $CH_3C_6H_4SO_3^-$, $CF_3C_6H_4SO_3^-$, $CH_3SO_3^-$, $CF_3SO_3^-$, $C_4F_9SO_3^-$, $C_6F_{13}SO_3^-$, $C_8F_{17}SO_3^-$, $C_6F_5SO_3^-$, $BF_4^-$, $AlF_4^-$, $AlCl_4^-$, $TiF_6^{2-}$, $PF_6^-$, $SbF_6^-$, $SbCl_6^-$, $GeF_6^-$, $ZrF_6^{2-}$, $AsF_6^-$, $FeCl_4^-$, $SnF_6^-$, $SnCl_6^-$ et $BiCl_6^-$, comme catalyseur de durcissement latent, on applique le mélange sur un substrat, on irradie le revêtement par une lumière actinique et ensuite on le chauffe à une température de 60°C à 200°C.

2. Procédé selon la revendication 1 caractérisé en ce qu'on utilise, comme poly-isocyanate, un mélange de polyisocyanates.

3. Procédé selon la revendication 1 caractérisé en ce qu'on utilise, comme poly-isocyanate, un diisocyanate ou triisocyanate aliphatique..

4. Procédé selon la revendication 1 caractérisé en ce qu'on ajoute au poly-isocyanate une petite quantité

7

d'un mono-isocyanate...

5. Procédé selon la revendication 1 caractérisé en ce qu'on utilise de 0,05 à 10% en poids, par rapport au polyisocyanate, d'un catalyseur de durcissement de formule I.

6. Procédé selon la revendication 1 caractérisé en ce qu'on utilise, comme catalyseur, un composé de formule I dans lequel $R^1$ représente le benzène, le toluène, un xylène, le cumène, le méthoxybenzène, le chlorobenzène, le chloro-4 toluène, le naphtalène, un méthylnaphtalène, un chloronaphtalène, un méthoxynaphtalène, le biphényle, l'indène, le pyrène, le dibenzothiophène, l'oxyde de diphényle, le stilbène ou le (butyl-4 benzyl)-9 anthracène.

7. Procédé selon la revendication 1 caractérisé en ce qu'on utilise, comme catalyseur, un composé de formule I dans lequel $R^1$ représente le toluène, un xylène, le cumène ou le chloro-4 toluène.

8. Procédé selon la revendication 1 caractérisé en ce qu'on utilise, comme catalyseur, un composé de formule I dans lequel $R^2$ représente un anion cyclopentadiényle ou un anion alkyl-cyclopentadiényle à alkyle en C1-C4.

9. Procédé selon la revendication 1 caractérisé en ce qu'on utilise, comme catalyseur, un composé de formule I dans lequel a est égal à 1 et $X^-$ représente un anion pris dans l'ensemble constitué par $BF_4^-$, $PF_6^-$, $SbF_6^-$, $AsF_6^-$, $CF_3SO_3^-$, $C_4F_9SO_3^-$, $C_8F_{17}SO_3^-$ et $CF_3COO^-$.

10. Procédé selon la revendication 1 caractérisé en ce qu'on utilise, pour l'irradiation, un rayonnement dont la longueur d'onde est comprise entre 200 600 nm.

11. Revêtement durci qui peut être obtenu par le procédé de la revendication 1.

12. Matière pour revêtement constituée d'un poly-isocyanate ou d'un mélange de poly-isocyanates, matière qui contient, comme catalyseur de durcissement latent, de 0,05 à 10% en poids, par rapport à l'isocyanate ou au mélange d'isocyanates, d'un composé de formule I selon la revendication 1.

13. Application de matières de revêtement selon la revendication 12 dans un procédé d'enregistrement d'images.

14. Application selon la revendication 12 à la réalisation d'images en relief.

15. Procédé pour réaliser photographiquement des images, procédé caractérisé en ce qu'on irradie conformément à une image un substrat recouvert d'un revêtement selon la revendication 11, puis on chauffe et ensuite on élimine au moyen d'un solvant les parties qui n'ont pas été touchées par le rayonnement.